# EUROPÄISCHE PATENTSCHRIFT

(11) **EP 0 402 900 B1**
(45) Veröffentlichungstag und Bekanntmachung des Hinweises auf die Patenterteilung: **14.12.1994**
(21) Anmeldenummer: 90111203.7
(22) Anmeldetag: 13.06.1990
(51) Int. Cl.: H01L 21/00, B25J 15/00

(54) **Haltevorrichtung zur Afnahme von scheibenförmigen Gegenständen, insbesondere Halbleiterscheiben, und Verwendung der Haltevorrichtung.**
Holding device for manipulating objects in a disc form, such as semiconductor wafers, and use of the holding device.
Dispositif de maintien pour prendre des objets en forme de disque, par exemple plaquettes semi-conductrices, utilisation du dispositif de maintient.

(30) Priorität: 15.06.1989 DE 3919611
(43) Veröffentlichungstag der Anmeldung: 19.12.1990
(73) Patentinhaber: Wacker-Chemitronic Gesellschaft für Elektronik-Grundstoffe mbH, D-84489 Burghausen (DE)
(72) Erfinder: Gerber, Hans Adolf, Dipl.-Ing. (FH), D-8263 Burghausen (DE); Hochgesang, Georg, Dipl.-Ing. (FH), D-8263 Burghausen (DE); Pardubitzki, Alfred, Dipl.-Ing. (FH), D-8263 Burghausen (DE); Schmiedlindl, Manfred, D-8269 Burgkirchen (DE); Zipf, Werner, Dipl.-Ing.(FH), D-8266 Töging (DE); Schweighofer, Arthur, Dipl.-Ing. (FH), D-8263 Burghausen (DE)

(56) Entgegenhaltungen:
- EP-A- 0 198 501
- FR-A- 2 567 160
- US-A- 4 323 155

## Beschreibung

Die Erfindung betrifft eine Haltevorrichtung zur Aufnahme von scheibenförmigen Gegenständen, insbesondere Halbleiterscheiben, mit einem Rahmen und von diesem ausgehenden, an der Scheibe angreifenden Halteelementen, bestehend aus einem gemeinsam mit der Scheibe transportierbaren, ringförmigen Rahmen mit mindestens drei tangential und/oder radial zum Außenumfang der Scheibe gerichteten, aus einer Halteposition in eine Freigabeposition überführbaren Halteelementen. Ferner betrifft die Erfindung die Verwendung der Haltevorrichtung.

Bei der Herstellung von Halbleiterscheiben als Ausgangsmaterial für elektronische Bauelemente oder Solarzellen fällt vor allem in der Endphase des Herstellungsprozesses eine Reihe von Prozeßschritten an, bei, vor und/oder nach denen die Scheiben Transportvorgängen unterworfen sind. Dies gilt insbesondere für Kontrollvorgänge, bei denen die Scheibenoberflächen auf Eigenschaften wie z.B. geometrische Perfektion, Partikelfreiheit oder chemische Reinheit untersucht werden, und Kennzeichnungsvorgänge, bei denen die Scheiben beispielsweise mit Markierungen oder Beschriftungen versehen werden, ehe sie in die Endverpackung eingebracht und versandfertig gemacht werden. Bisher werden bei derartigen Vorgängen zum Halten und Transportieren der Scheiben spezielle Greifvorrichtungen, wie etwa Vakuumaufnehmer oder Greifzangen mit einem die Scheiben berührungsfrei teilweise umgebenden Rahmen und am Außenumfang der Scheiben angreifenden, manuell bedienten Halteelementen eingesetzt. Die Vakuumaufnehmer haben jedoch - wie auch der Scheibentransport über Transportriemen - den Nachteil, daß selbst ein schonender Kontakt mit der Scheibenoberfläche zu Störungen führt. Diese lassen sich beispielsweise mit Hilfe von Partikelmessungen oder bestimmten Ätzlösungen sichtbar machen, wobei das festgestellte Muster dann die Spur des Transportriemens oder des Vakuumaufnehmers auf der Scheibenoberfläche erkennen läßt. Die bekannten Greifzangen vermeiden zwar diesen Nachteil, sind aber schwierig zu bedienen, da sie zum Greifen sehr genau positioniert werden müssen, was auf Dauer manuell nicht durchführbar ist. Darüber hinaus sind diese Greifzangen unhandlich und kommen daher, wie auch die Vakuumaufnehmer, nur für den ortsgebundenen Einsatz, nicht aber für weitere Transportwege in Frage, so daß die Scheiben an verschiedenen Einsatzorten nach dem Transport jeweils ergriffen und wieder weitergegeben werden müssen. Bei jedem dieser Greifvorgänge besteht natürlich das Risiko einer Beschädigung der empfindlichen Scheiben.

In der europäischen Patentanmeldung EP-198501 wird eine Haltevorrichtung beschrieben, mit der scheibenförmige Gegenstände am Außenumfang gehalten und transportiert werden können.

Die Aufgabe der Erfindung bestand darin, eine Haltevorrichtung anzugeben, die einerseits die schonende, einfache und zuverlässige Aufnahme und Freigabe von scheibenförmigen Gegenständen, insbesondere Halbleiterscheiben gestattet und andererseits es ermöglicht, die Anzahl der erforderlichen Greifvorgänge zu verringern.

Gelöst wird die Aufgabe durch eine Haltevorrichtung der eingangs genannten Art, die dadurch gekennzeichnet ist, daß der Rahmen berührungsfrei und geschlossen die Scheibe umgibt, und daß die Halteelemente die Scheibe so halten, daß deren gesamte Oberfläche frei zugänglich ist.

Der Rahmen kann beispielsweise in Form eines Ringes oder einer Lochscheibe gestaltet sein, wobei das Innenloch einen gegenüber dem Außendurchmesser der zu haltenden Scheibe größeren Durchmesser aufweist. Eine solche kreis- oder ringförmige Geometrie des Rahmens ist zwar bevorzugt, jedoch nicht zwingend vorgeschrieben; es sind auch Ausführungsformen mit polygonalem, z.B. trigonalem, quadratischem, oder insbesondere hexagonalem oder oktagonalem Außen- und/oder Innenumfang möglich. Vorteilhaft ist der Rahmen in sich geschlossen und umgibt somit den gesamten Außenumfang der Scheibe.

Vorteilhaft wird der Rahmen aus Kunststoffen gefertigt, die die erforderliche mechanische Stabilität besitzen sowie sich unter den Prozeßbedingungen inert verhalten und keine unzulässige Kontamination der Scheiben verursachen können. Beispiele für geeignete Kunststoffe sind Thermoplaste wie Polytetrafluorethylen, Polyethylen, Polyvinylchlorid oder insbesondere Duroplaste wie Phenol-, Epoxid- oder Polyesterharze, die gegebenenfalls auch, beispielsweise durch die Einlagerung von Fasern, etwa Glas- oder Carbonfasern, oder das Auf- oder Einbringen von stabilisierenden Schichten verstärkt sein können. Eine andere Möglichkeit besteht darin, Material auf beispielsweise keramischer oder metallischer Basis einzusetzen, wie etwa Edelstahl, Aluminium oder Buntmetall, wobei gegebenenfalls auch eine Ummantelung mit Kunststoff vorgesehen sein kann. Selbstverständlich sind bei der Auswahl solcher Materialien die jeweiligen Reinheitsanforderungen und Kontaminationsrisiken im besonderen Maße zu berücksichtigen.

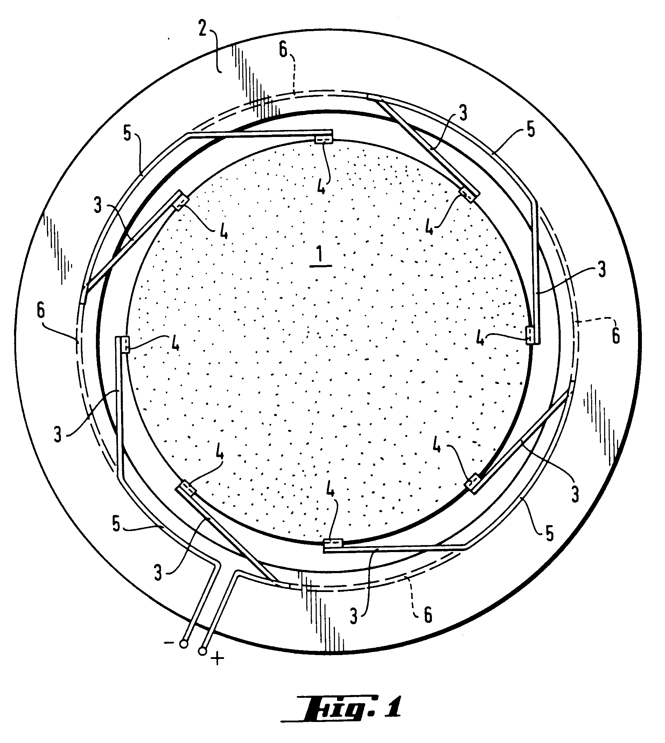

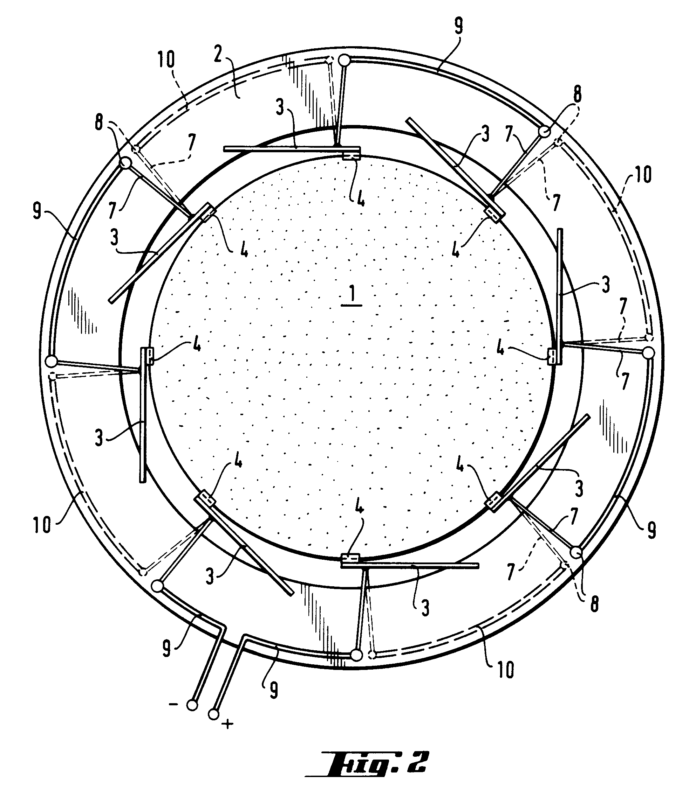

In den Figuren 1 und 2 sind mögliche Ausführungsformen von erfindungsgemäßen Haltevorrichtungen beispielhaft dargestellt. Figur 1 zeigt dabei eine Haltevorrichtung mit Federzungen aus Thermobimetall als Halteelementen, Figur 2 eine solche mit Halteelementen, die mittels sich durch Wärmeeinwirkung kontrahierender Drähte aus der Halte- in die Freigabeposition übergeführt werden können. Analoge Bestandteile sind in beiden Figuren durch die gleichen Bezugszeichen gekennzeichnet.

Die in den Figuren 1 und 2 dargestellte Haltevorrichtung dient dabei zur Aufnahme einer Scheibe 1, die insbesondere aus Halbleitermaterial wie Silicium, Germanium, Galliumarsenid oder Indiumphosphid, aber auch beispielsweise aus Glas, oxidischem Material wie Gallium-Gadolinium-Granat, Spinell oder Rubin, oder anderen Materialien mit empfindlichen Oberflächen bestehen kann. Beispiele hierfür sind etwa Scheiben für optische oder magnetische Speicher.

In Fig. 1 wird die Scheibe von einem ringförmigen, flachen Rahmen 2 aus vorzugsweise Kunststoff berührungsfrei umschlossen; die Breite des freibleibenden, beispielsweise ringspaltförmigen und gegebenenfalls auch Ausnehmungen oder Verengungen aufweisenden Zwischenraumes kann innerhalb weiter Grenzen variiert werden. Die Untergrenze richtet sich nach der freien Weglänge, die von den Halteelementen für die Überführung in eine für eine einwandfreie Scheibenaufnahme geeignete Freigabeposition benötigt wird. Die Obergrenze kann an die Erfordernisse des jeweiligen Einsatzgebietes angepaßt werden, beispielsweise wenn die Scheibenoberfläche, etwa für Reinigungs- oder Meßvorgänge, in bestimmter Weise umströmt oder zugänglich sein soll. Bei der Herstellung von Halbleiterscheiben hat sich der Einsatz von Kunststoffrahmen mit einer Breite von vorteilhaft 25 bis 50 mm und einer Dicke von günstig 3 bis 8 mm als zweckmäßig erwiesen.

In den Rahmen 2 eingebettet, beispielsweise eingegossen, sind die Enden der Halteelemente 3, die tangential zum Außenumfang der Scheibe gerichtet sind und in der hier dargestellten Halteposition mit ihrem freien Endbereich mit den Scheiben an deren Außenumfang in Kontakt kommen und diese damit fixieren. Zur Vermeidung von Kontamination der Scheibe sind vorteilhaft die Halteelemente zumindest im Endbereich mit Auflagestücken 4 versehen, die aus dem selben Material wie die Scheibe bestehen, also beispielsweise hochreinem Silicium oder Galliumarsenid, wenn Silicium- oder Galliumarsenidscheiben aufgenommen werden sollen, wobei gegebenenfalls auch entsprechend dotiertes Material verwendet werden kann. Diese Auflagestücke können beispielsweise durch Kleben auf den Halteelementen befestigt sein. Günstig besitzen sie in ihrem mit der Scheibe in Kontakt kommenden Bereich ein Profil, das paßgerecht zur Außenkante der Scheibe geformt, also beispielsweise entsprechend konkav gerundet ist.

Die Anzahl der Halteelemente beträgt mindestens drei; es wurde jedoch gefunden, daß sich bei Halbleiterscheiben insbesondere im Durchmesserbereich von etwa 10 cm und darüber mit 6 bis 10, vorzugsweise 8 Halteelementen eine besonders zuverlässige und stabile Aufnahme, Halterung und Freigabe der Scheiben erzielen läßt. Zweckmäßig sind die Halteelemente rotationssymmetrisch über den Innenumfang des Rahmens verteilt.

Bewährt hat es sich insbesondere, die Halteelemente als Federzungen zu gestalten. Vorteilhaft sind diese Federzungen so angeordnet, daß sie gegenüber der zu haltenden Scheibe vorgespannt sind, so daß die Kraft, mit der diese in der Halteposition gehalten wird, auf diese Weise vorgegeben ist. Obwohl es grundsätzlich nicht ausgeschlossen ist, Halteelemente und insbesondere Federzungen vorzusehen, die durch manuell ausgeübte mechanische Kräfte aus der Halte- in die Freigabeposition und umgekehrt übergeführt werden, werden gemäß der bevorzugten Ausführungsform der Erfindung solche Halteelemente, insbesondere Federzungen eingesetzt, bei denen dieser Übergang mit Hilfe von elektrischem Strom erzielt werden kann. Dies kann beispielsweise mit Hilfe von Federzungen aus geschlitzten, endverbrückten Streifen aus Thermobimetall geschehen, welche sich bei Stromdurchgang erwärmen und verbiegen, und dadurch den Kontakt zur Scheibe verlieren und diese freigeben. Schaltungstechnisch kann dies beispielsweise in der in der Figur schematisch gezeigten Weise dadurch geschehen, daß auf der Vorderseite und der Rückseite des Rahmens 2 Stromleitungen 5 und 6 vorgesehen sind, durch welche die als geschlitzte Federzungen gestalteten Halteelemente 3 in Reihe geschaltet sind. Wird nun elektrische Energie in dieses System eingespeist, erwärmen sich die vom Strom durchflossenen Thermobimetallfedern und biegen sich aus der im stromlosen, erkalteten Zustand eingenommenen Halteposition nach außen in die dem stromdurchflossenen erwärmten Zustand entsprechende Freigabeposition. Dabei wird die eingespannte Scheibe 1 freigegeben und kann entnommen oder abgelegt werden. Umgekehrt wird zum Einspannen einer Scheibe zunächst Strom angelegt, um die Thermobimetallfederzungen in die Freigabeposition zu bringen. Nun wird ins Zentrum der Vorrichtung die aufzunehmende Scheibe in die vorgesehene Position eingelegt und die Stromzufuhr unterbrochen. Dadurch erkalten die Bimetallfederzungen und bewegen sich allmählich wieder in die Halteposition zurück, wobei sie zunächst die Scheibe berühren und bei weiterer Abkühlung die Haltekraft aufbauen. Diese gewährleistet den sicheren Sitz der Scheibe in der Halterung und ermöglicht es, Scheibe und Haltevorrichtung gemeinsam zu transportieren und ohne Scheibenentnahme Behandlungsvorgänge oder Prozeßschritte wie beispielsweise Messungen und/oder Beschriftung mittels Laser durchzuführen.

Eine andere mögliche Ausführungsform kann beispielsweise in der in Fig. 2 dargestellten Art aufgebaut sein. Dabei sind in den Rahmen 2 Federzungen 3 aus federsteifem Material, z.B. Metall wie Federstahl, Berylliummetall oder -legierungen, oder federsteifen Kunststoffen eingelassen, die tangential auf den Außenumfang der Scheibe weisen. Diese Federzungen sind bevorzugt ebenfalls mit Auflagestücken 4 aus dem Scheibenmaterial versehen, welche in ihrem Querschnitt der Scheibenkantenform angepaßt sind. Die Federzungen sind so vorgespannt, daß sie in der Halteposition auf die aufgenommene Scheibe 1 die erforderliche Haltekraft ausüben können. Die Überführung in die Freigabeposition erfolgt über Zugdrähte 7, die sich bei Erwärmung verkürzen. Diese Eigenschaft besitzen bestimmte Legierungen, insbesondere Nickel/Titan-Legierungen, die als sogenannte "Formgedächtnislegierungen" oder "Memory-Legierungen" wie etwa die Legierung mit der Bezeichnung "Nitinol" bekannt geworden sind (s. hierzu beispielsweise Kirk-Othmer (3) 20: 726-736). Ein Beispiel für eine besonders gut geeignete Legierung ist die unter der Bezeichnung "Biometal" vertriebene und erhältliche Titan-Nickel-Legierung. Drähte aus derartigen Legierungen ziehen sich bei elektrischer Erwärmung zusammen und können dadurch im vorliegenden Fall die Federzungen nach außen ziehen. Zweckmäßig sind zum Vorspannen dieser Zugdrähte aus beispielsweise der als "Biometal" bezeichneten Titan-Nickel-Legierung zusätzliche Spannelemente 8, wie etwa Stellschrauben oder Exzenter, vorgesehen, mit denen sich ihre Länge genau einstellen läßt. Zur Versorgung mit elektrischem Strom können die Zugdrähte beispielsweise über auf der Vorder- bzw. Rückseite des. Rahmens verlaufende Leiterbahnen 9 und 10 verbunden sein, wobei zweckmäßig eine Reihenschaltung gewählt wird.

Bewährt haben sich auch Anordnungen, bei denen ein einzelner Zugdraht mit jeweils einer Federzunge verbunden ist, wobei diese dann in den Stromkreis mit einbezogen werden. Um die erforderliche Arbeitslänge bei der Kontraktion der Zugdrähte zu gewährleisten, kann es auch erforderlich sein, diese in gewendelter Form einzusetzen.

Die Aufnahme bzw. die Freigabe der Scheibe erfolgt analog der bei der Erläuterung der Fig. 1 beschriebenen Verfahrensweise, mit dem Unterschied, daß die Federzungen durch die elektrisch beheizten Zugdrähte aus der Halteposition in die Freigabeposition gebracht werden. Die Stromeinspeisung kann an beliebiger Stelle über die Leiterbahnen erfolgen.

Neben den genannten bevorzugten Ausführungsformen sind auch Haltevorrichtungen nicht ausgeschlossen, bei denen die Halteelemente gelenkig gelagert sind und beispielsweise mit Hilfe von auf ihr der Scheibe abgewandtes Ende einwirkenden Druckfedern in die Freigabeposition überführt werden können. Eine andere Möglichkeit besteht darin, mittels eines externen Öffners die Halteelemente aus der Halteposition in die Freigabe- bzw. Aufnahmeposition aufzuspreizen. Zusätzlich zu diesen Varianten, bei denen die Halteelemente tangential zum Außenumfang der Scheibe gerichtet sind, während die Haltekraft radial an der Scheibe angreift und die sich durch eine besonders stabile Scheibenpositionierung auszeichnen, sind auch Ausführungsformen möglich, bei denen die Halteelemente radial zum Außenumfang der Scheibe gerichtet sind. Beispielsweise kann der Rahmen 2 mit Ausnehmungen versehen sein, in welche radial zum Scheibenmittelpunkt ausgerichtet Druckfedern eingepaßt sind, welche wiederum die eigentlichen Haltestifte an den Scheibenrand drücken. Zur Aufnahme bzw. Freigabe der Scheiben werden, beispielsweise mechanisch oder vermittels Zugdrähten oder Magneten, die Haltestifte nach außen in die Freigabeposition gezogen. Derartige Haltevorrichtungen sind jedoch aufwendiger herzustellen, insbesondere wenn geringfügige Bewegungen und Vibrationen der gehaltenen Scheibe ausgeschlossen werden sollen.

Die erfindungsgemäße Haltevorrichtung ermöglicht die sichere und zuverlässige Handhabung von Halbleiterscheiben, wobei durch die am Außenumfang angreifenden Halteelemente nicht nur Störungen der Scheibenoberfläche ausgeschlossen sind, sondern auch eine genaue Zentrierung der gehaltenen Scheiben relativ zum Rahmen gewährleistet ist. Ein Vorteil liegt darin, daß die in der Haltevorrichtung befindliche Scheibe auf einem definierten Potential gehalten werden kann, so daß elektrostatische Aufladungen verhindert werden. Ein weiterer Vorteil liegt in der einfachen Handhabung und der Vielseitigkeit, da die Haltevorrichtung sowohl manuell als auch maschinell be- und entladen sowie transportiert werden kann. In einer Weiterbildung des Erfindungsgedankens ist vorgesehen, den Rahmen beispielsweise durch entsprechende Formgebung stapelbar zu gestalten, so daß die Haltevorrichtungen mitsamt den Scheiben auch zwischen einzelnen Prozeßschritten zwischengelagert oder versandt werden können.

Der Hauptvorteil der Haltevorrichtung liegt darin, daß sie die aufgenommene Scheibe bei verschiedenen Transport- und Prozeßschritten begleiten kann und somit die Zahl der Aufnahme- und Freigabevorgänge deutlich verringert werden kann. Die Haltevorrichtung wird mit besonderem Vorteil bei der Fertigung von Halbleiterscheiben eingesetzt, und zwar insbesondere in dem Herstellungsstadium, in dem die Scheiben die mechanischen und chemischen Behandlungsschritte (wie z.B. Polieren, Ätzen, oder Reinigungsvorgänge ) bereits durchlaufen haben und für die Verpackung und den Versand vorbereitet werden. Dabei werden an den Scheiben verschiedene Meß- und Testoperationen durchgeführt, wie etwa visuelle Inspektion oder Partikel-, Widerstands- oder Geometriemessung, wobei gegebenenfalls auch eine Beschriftung mit Lasergeräten und/oder eine definierte Ausrichtung vorgesehen sein kann. Alle diese Prozeßschritte und die damit verbundenen Transportvorgänge können mit in der Haltevorrichtung befindlichen Scheiben durchgeführt werden, ohne daß eine Entnahme erforderlich ist. Die erhaltenen Scheiben sind frei von den durch Riementransport und/oder Vakuumaufnehmer verursachten Störungen im Oberflächenbereich. Für die Übergabe oder Übernahme einer Scheibe in die Haltevorrichtung eignen sich beispielsweise diejenigen in der Halbleitertechnik üblichen Transport- und Behandlungssysteme, mit deren Hilfe die Scheibe in eine Position gebracht werden kann, in welcher der Scheibenumfang für den Angriff der Halteelemente zugänglich ist. Die Haltevorrichtung mit den Halteelementen, die sich zunächst in Freigabeposition befinden, kann dabei, beispielsweise mittels Positionierstiften, Greifvorrichtungen oder anderen Halte- oder Positioniersystemen, in einer geeigneten Relativposition bezüglich der Scheibe gehalten werden, bis die Halteelemente in die Halteposition übergegangen sind. Danach kann die Haltevorrichtung gemeinsam mit der Scheibe entnommen und dem nächsten Prozeßschritt zugeführt werden. In analoger Weise kann bei der Freigabe einer Scheibe die Haltevorrichtung in eine geeignete Relativposition bezüglich des für die Aufnahme der Scheibe vorgesehenen Systems gebracht werden, worauf, beispielsweise mittels Stromdurchgang, die Halteelemente in die Freigabeposition übergeführt werden und die Scheibe freigegeben werden kann. Die Haltevorrichtung kann dann an anderer Stelle erneut zur Aufnahme einer Scheibe eingesetzt werden.

## Patentansprüche

1. Haltevorrichtung zur Aufnahme von scheibenförmigen Gegenständen, insbesondere Halbleiterscheiben, bestehend aus einem gemeinsam mit der Scheibe (1) transportierbaren, ringförmigen Rahmen (2) und mindestens drei tangential und/oder radial zum Außenumfang der Scheibe gerichteten, aus einer Halteposition in eine Freigabeposition überführbaren Halteelementen (3), dadurch, gekennzeichnet daß
der Rahmen (2) berührungsfrei und geschlossen die Scheibe umgibt; und daß
die Halteelemente (3) die Scheibe (1) so halten, daß deren gesamte Oberfläche frei zugänglich ist.

2. Haltevorrichtung nach Anspruch 1, gekennzeichnet durch 6 bis 10 Halteelemente.

3. Haltevorrichtung nach einem der Ansprüche 1 bis 2, dadurch gekennzeichnet, daß die mit den Scheiben in Kontakt kommenden Flächen der Halteelemente mit Auflagestücken (4) aus dem Material, insbesondere Halbleitermaterial versehen sind, aus dem auch die Scheiben bestehen.

4. Haltevorrichtung nach einem der Ansprüche 1 bis 3, dadurch gekennzeichnet, daß als Halteelemente Federzungen vorgesehen sind.

5. Haltevorrichtung nach einem der Ansprüche 1 bis 4, dadurch gekennzeichnet, daß als Halteelemente durch die Einwirkung von elektrischem Strom aus der Halteposition in die Freigabeposition überführbare Federzungen vorgesehen sind.

6. Verwendung der Haltevorrichtung gemäß einem der Ansprüche 1 bis 5 zum Halten und Transportieren einer Halbleiterscheibe während eines oder mehrerer Prozeßschritte.

7. Verwendung der Haltevorrichtung nach Anspruch 6, dadurch gekennzeichnet, daß mindestens ein Prozeßschritt eine optische Oberflächenuntersuchung ist.

8. Verwendung der Haltevorrichtung nach Anspruch 6, dadurch gekennzeichnet, daß mindestens ein Prozeßschritt eine Beschriftung der Scheibe mittels Laserstrahl ist.

## Claims

1. Holding device for receiving wafer-like objects, in particular semiconductor wafers, which comprises an annular frame (2) which can be transported jointly with the wafer (1), and at least three holding elements (3), directed tangentially and/or radially toward the outside circumference of the wafer, which can be converted from a holding position to a release position, characterized in that the frame (2) surrounds the wafer in a contact-less and closed fashion; and in that the holding elements (3) hold the wafer (1) such that the entire surface thereof is freely accessible.

2. Holding device according to Claim 1, characterized by 6 to 10 holding elements.

3. Holding device according to either of Claims 1 or 2, characterized in that the surfaces, which come into contact with the wafers, of the holding elements are provided with supporting pieces (4) composed of the material, in particular semiconductor material, of which the wafers are also composed.

4. Holding device according to any of Claims 1 to 3, characterized in that spring tongues are provided as holding elements.

5. Holding device according to any of Claims 1 to 4, characterized in that spring tongues which can be converted from the holding position to the release position by the action of electric current are provided as holding elements.

6. Use of the holding device according to any of Claims 1 to 5 for holding and transporting a semiconductor wafer during one or more process steps.

7. Use of the holding device according to Claim 6, characterized in that at least one process step is an optical surface examination.

8. Use of the holding device according to Claim 6, characterized in that at least one process step is an inscription of the wafer by means of a laser beam.

## Revendications

1. Dispositif de maintien pour prendre des objets en forme de disques, en particulier de disques semiconducteurs, se composant d'un cadre (2) annulaire transportable dans son ensemble avec le disque (1), et d'au moins trois éléments de maintien (3) déplaçables d'une position de maintien à une position de libération, et dirigés tangentiellement et/ou radialement par rapport au périmètre extérieur du disque, caractérisé en ce que le cadre (2) entoure le disque de manière fermée et sans entrer en contact avec lui ; et en ce que les éléments de maintien (3) assurent le maintien du disque (1) de sorte que la totalité de la surface extérieure de ce dernier soit entièrement accessible.

2. Dispositif de fixation selon la revendication 1, caractérisé par l'utilisation de 6 à 10 éléments de maintien.

3. Dispositif de maintien selon l'une des revendications 1 ou 2, caractérisé en ce que les surfaces des éléments de maintien, venant en contact avec les disques, sont pourvues de pièces d'appui (4) en même matériau, en particulier semi-conducteur, que celui constituant les disques.

4. Dispositif de maintien selon l'une des revendications 1 à 3, caractérisé en ce que sont prévues, en tant qu'éléments de maintien, des languettes à ressort.

5. Dispositif de maintien selon l'une des revendications 1 à 4, caractérisé en ce que sont prévues, en tant qu'élément de maintien, des languettes à ressort déplaçables de la position de maintien à la position de libération sous l'action d'un champ électrique.

6. Utilisation du dispositif de maintien selon l'une des revendications 1 à 5, au maintien et au transport d'un disque semi-conducteur durant une ou plusieurs étapes de procédé.

7. Utilisation du dispositif de maintien selon la revendication 6, caractérisée en de qu'au moins une étape de procédé est une analyse optique de la surface extérieure.

8. Utilisation du dispositif de maintien selon la revendication 6, caractérisée en ce qu'au moins une étape de procédé est un marquage du disque au moyen d'un rayon laser.
